# EUROPEAN PATENT APPLICATION

(11) **EP 4 603 816 A1**
(43) Date of publication of application: **20.08.2025**
(21) Application number: 25153012.7
(22) Date of filing: 21.01.2025
(51) Int. Cl.: G01L 19/00, G01L 19/06, G01L 19/14

(54) **OVERMOULDED PRESSURE SENSOR WITH ENCAPSULATING GEL AND METAL COVER ON SUBSTRATE**

(30) Priority: 19.02.2024 IN 202411011391
(71) Applicant: HONEYWELL INTERNATIONAL INC., Charlotte, NC 28202 (US)
(72) Inventor: BORAIAH, Manjesh Kumar, Charlotte, 28202 (US); GANGARAJU, Charlotte, 28202 (US)
(74) Representative: Haseltine Lake Kempner LLP

(57) **Abstract**

A device for sensing characteristics of the environment and/or various media such as pressure is provided. The assembled device may include a sensor module having gel encapsulation, metal covers, and plastic overmoulding. Associated methods for assembling devices having overmoulded pressure sensor modules with gel encapsulation and metal covers are provided.

## Description

### FIELD OF THE INVENTION

Embodiments of the present disclosure generally relate to devices comprising pressure sensors having overmoulding, and, more particularly, to such devices having gel encapsulation and metal covers.

### BACKGROUND

There are many different devices for sensing characteristics of various media. Some of these devices use one or more sensor modules to measure one or more characteristics of media, such as the pressure.

Some of these devices are used in the medical field, in some examples. For example, a hemodialysis device pumps blood from a patient to a filter that removes waste from the blood, typically via a dialysate, and then pumps the blood back to the patient. Such hemodialysis devices often have one or more pressure sensor modules that measure the pressure of the blood as it is being pumped to the filter and as it is being pumped back to the patient.

Applicant has identified many technical challenges and difficulties associated with such devices for overmoulded pressure sensor modules with gel encapsulation and metal covers. Through applied effort, ingenuity, and innovation, many of these identified problems have been solved by developing solutions that are included in embodiments of the present disclosure, many examples of which are described in detail herein.

### BRIEF SUMMARY

Various embodiments described herein relate to devices sensing characteristics of various media, and associated methods for assembling overmoulded pressure sensor modules with gel encapsulation and metal covers.

In accordance with various embodiments of the present disclosure, a device for sensing characteristics of various media is provided. In some embodiments, the device for sensing characteristics of various media comprises a housing for a sensor module. In some embodiments, the sensor module comprises: a substrate for housing a pressure sensor module; at least one sensing element for sensing one or more characteristics of an environment of the sensor module, wherein the at least one sensing element is coupled to the substrate; a gel encapsulation of the at least one sensing element; a metal cover for covering the at least one sensing element and the gel encapsulation, wherein the metal cover is coupled to the substrate; and a plastic overmoulding defining a pressure opening, wherein the plastic overmoulding is deformable such that it covers the metal cover and the substrate.

In some embodiments, the sensor module comprises a plurality of electrical terminals configured to complete an electrical connection between the at least one sensing element of the sensor module and the device via physical contact with at least a portion of the device.

In some embodiments, the sensor module is a pressure sensor module.

In some embodiments, the substrate is comprised of one or more of: flame-retardant woven glass-reinforced epoxy resin (FR4); or thin film nanocomposite (tFN).

In some embodiments, the substrate further comprises: at least one microelectromechanical system (MEMS) pressure sensor; and at least one application-specific integrated circuit (ASIC).

In some embodiments, the gel is comprised of at least one of: silicone gel; or a Fluorosilicone gel.

In some embodiments, the metal cover is comprised of at least one of: stainless steel; or aluminum.

In some embodiments, the plastic overmoulding is comprised of at least one of: engineering plastics suiting application needs; high-temperature plastics; nylon; Bisphenol S (BPS), or liquid-crystal polymers (LCP).

In accordance with various embodiments of the present disclosure, a sensor module is provided. In some embodiments, the sensor module comprises: a substrate for housing a pressure sensor module; at least one sensing element for sensing one or more characteristics of an environment of the sensor module, wherein the at least one sensing element is coupled to the substrate; a gel encapsulation of the at least one sensing element; a metal cover for covering the at least one sensing element and the gel encapsulation, wherein the metal cover is coupled to the substrate; a plastic overmoulding defining a pressure opening, wherein the plastic overmoulding is deformable such that it covers the metal cover and the substrate; and a plurality of electrical terminals configured to complete an electrical connection between the at least one sensing element of the sensor module and an external device via physical contact with at least a portion of the external device.

In some embodiments, the sensor module is a pressure sensor module.

In some embodiments, the substrate is comprised of one or more of: flame-retardant woven glass-reinforced epoxy resin (FR4); or thin film nanocomposite (tFN).

In some embodiments, the substrate further comprises: at least one microelectromechanical system (MEMS) pressure sensor; and at least one application-specific integrated circuit (ASIC).

In some embodiments, the gel is comprised of at least one of: silicone gel; or a Fluorosilicone gel.

In some embodiments, the metal cover is comprised of at least one of: stainless steel; or aluminum.

In some embodiments, the plastic overmoulding is comprised of at least one of: engineering plastics suiting application needs; high-temperature plastics; nylon; Bisphenol S (BPS), or liquid-crystal polymers (LCP).

In accordance with various embodiments of the present disclosure, a method for assembling a device comprising a sensor module is provided. In some embodiments, the method comprises: assembling electronics of a pressure sensor module onto a substrate, wherein the electronics comprise at least one sensing element; coupling a metal cover to the pressure sensor module; dispensing a gel material for encapsulating the at least one sensing element of the pressure sensor module; coupling a plurality of electrical terminals to the substrate; and coupling a plastic overmoulding to the pressure sensor module.

In some embodiments, the coupling the metal cover further comprises: applying at least one industrial grade epoxy for adhering the metal cover to the pressure sensor module; coupling the metal cover to the at least one applied industrial grade epoxy; and curing the at least one industrial grade epoxy.

In some embodiments, the coupling the plastic overmoulding to the pressure sensor module further comprises inserting the pressure sensor module into a moulding machine for applying the plastic overmoulding to the pressure sensor module.

In some embodiments, the substrate further comprises: at least one microelectromechanical system (MEMS) pressure sensor; and at least one application-specific integrated circuit (ASIC).

In some embodiments, the plastic overmoulding is comprised of at least one of: engineering plastics suiting application needs; high-temperature plastics; nylon; Bisphenol S (BPS); or liquid-crystal polymers (LCP).

The foregoing illustrative summary, as well as other exemplary objectives and/or advantages of the disclosure, and the manner in which the same are accomplished, are further explained in the following detailed description and its accompanying drawings.

### BRIEF DESCRIPTION OF THE DRAWINGS

The description of the illustrative embodiments may be read in conjunction with the accompanying figures. It will be appreciated that, for simplicity and clarity of illustration, elements illustrated in the figures have not necessarily been drawn to scale, unless described otherwise. For example, the dimensions of some of the elements may be exaggerated relative to other elements, unless described otherwise. Embodiments incorporating teachings of the present disclosure are shown and described with respect to the figures presented herein, in which:
FIG. 1 is a perspective view of an example device for sensing characteristics of various media, with an overmoulded sensor module, in accordance with some embodiments of the present disclosure;
FIG. 2 is a cross-sectional view of the device of FIG. 1, showing the sensor module with gel encapsulation, a cover, and overmoulding;
FIG. 3 is a series of perspective views showing the assembly of the device of FIG. 1; and
FIG. 4 is an example flowchart illustrating an example method of assembling a device for sensing characteristics of various media, in accordance with some embodiments of the present disclosure.

### DETAILED DESCRIPTION OF THE INVENTION

Some embodiments of the present disclosure will now be described more fully hereinafter with reference to the accompanying drawings, in which some, but not all embodiments of the disclosure are shown. Indeed, these disclosures may be embodied in many different forms and should not be construed as limited to the embodiments set forth herein; rather, these embodiments are provided so that this disclosure will satisfy applicable legal requirements. Like numbers refer to like elements throughout.

As used herein, terms such as "front," "rear," "top," "bottom," "left," "right," etc. are used for explanatory purposes in the examples provided below to describe the relative position of certain components or portions of components. Furthermore, as would be evident to one of ordinary skill in the art in light of the present disclosure, the terms "substantially" and "approximately" indicate that the referenced element or associated description is accurate to within applicable engineering tolerances.

As used herein, the term "comprising" means including but not limited to and should be interpreted in the manner it is typically used in the patent context. Use of broader terms such as comprises, includes, and having should be understood to provide support for narrower terms such as consisting of, consisting essentially of, and comprised substantially of.

The phrases "in one embodiment," "according to one embodiment," "in some embodiments," and the like generally mean that the particular feature, structure, or characteristic following the phrase may be included in at least one embodiment of the present disclosure and may be included in more than one embodiment of the present disclosure (importantly, such phrases do not necessarily refer to the same embodiment).

The phrases "in one example," "according to one example," "in some examples," and the like generally mean that the particular feature, structure, or characteristic following the phrase may be included in at least one example of the present disclosure and may be included in more than one example of the present disclosure (importantly, such phrases do not necessarily refer to the same example).

If the specification states a component or feature "may," "can," "could," "should," "would," "preferably," "possibly," "typically," "optionally," "for example," "as an example," "in some examples," "often," or "might" (or other such language) be included or have a characteristic, that specific component or feature is not required to be included or to have the characteristic. Such component or feature may be optionally included in some examples, or it may be excluded.

The word "example" or "exemplary" is used herein to mean "serving as an example, instance, or illustration." Any implementation described herein as "example" or "exemplary" is not necessarily to be construed as preferred or advantageous over other implementations.

The term "electrically coupled," "electrically coupling," "electrically couple," "electrically connected," "electrically connecting," "electrically connect," "in communication with," or "in electronic communication with" in the present disclosure refers to two or more elements or components being connected through wired means and/or wireless means, such that signals, electrical voltage/current, data and/or information may be transmitted to and/or received from these elements or components.

The term "in fluid communication with" in the present disclosure refers to two or more elements or components being connected through one or more paths or pathways, such that a fluid or other flowing media may be input to and/or output from these elements or components.

The term "component" may refer to an article, a device, or an apparatus that may comprise one or more surfaces, portions, layers and/or elements. For example, an example component may comprise one or more substrates that may provide underlying layer(s) for the component and may comprise one or more elements that may form part of and/or are disposed on top of the substrate. In the present disclosure, the term "element" may refer to an article, a device, or an apparatus that may provide one or more functionalities.

The term "sensor module" refers to a component that may detect, measure, and/or identify any one or more attributes or characteristics of an environment or media, including but not limited to pressure(s).

Conventional board mount pressure sensors, in some examples, are limited to conventional medical device and/or industrial and/or household appliance applications due to various limitations. These limitations include the conventional board mount pressure sensors having multiple adhesive joints, having limitations in environments of high temperature (e.g., approximately 100 degrees Celsius and/or above) and/or high pressure (e.g., approximately 12 bar and/or above), having limitations due to unreliability of adhesive joints under such operating conditions, and failing to meet at least some pressure sensor safety requirements (e.g., for batteries).

Embodiments of the present disclosure, in some examples, provide a device for sensing characteristics (e.g., pressure) of various media via a sensor module having gel encapsulation, a metal cover, and plastic overmoulding. Example embodiments of the present disclosure provide a board mount pressure sensor for sensing pressure of various media, wherein the board mount pressure sensor includes gel encapsulation, a metal cover, and plastic overmoulding. In some embodiments, the types of media being sensed comprise any kind of fluid. Example embodiments of the present disclosure provide a pressure sensor having one or more pressure ports. In some embodiments, the one or more pressure ports can carry the same or different media types, in some examples.

Example embodiments of the present disclosure provide a waterproof and/or water-resistant encapsulation via the gel encapsulation. Example embodiments of the present disclosure provide a mechanically robust assembly with minimal joints, in some examples, at which the sensor module can get separated from the device substrate. Example embodiments of the present disclosure comprise provide an efficient method of assembly that lends itself to scalability and large-scale production. Example embodiments of the present disclosure provide assembled devices having a low form factor.

As described above, embodiments of the present disclosure, in some examples, provide devices for sensing characteristics of various media are often used in the medical field, the automotive field, the heating/ventilation/air conditioning (HVAC) field, the household appliance field, etc. For example, in coffee machines, a device having a pressure sensor can be used to sense and/or control the pressure at which brewing takes place.

To address challenges and limitations associated with devices for sensing characteristics of various media, various examples of the present disclosure may be provided. For example, various examples of the present disclosure may provide example devices for sensing characteristics of various media, associated sensor modules, and associated methods. In some embodiments, the present disclosure may provide a device for sensing pressure of various media and an associated sensor module having gel encapsulation, a metal cover, and plastic overmoulding.

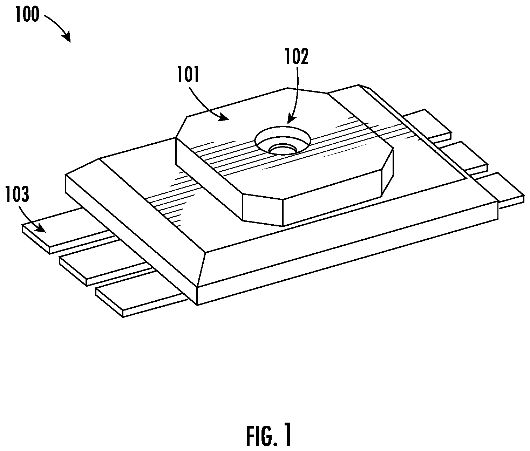

Referring now to FIG. 1, a perspective view of an example device for sensing characteristics of various media, having a housing for an overmoulded sensor module, is illustrated. In some examples, the sensor module may be a pressure sensor module. FIG. 1 shows a pressure sensor module 100. In some examples, the pressure sensor module 100 includes the metal cover and the substrate.

In some embodiments, the pressure sensor module 100 includes a plastic overmoulding 101. The plastic overmoulding 101 is sized such that it fits over or otherwise covers components of the pressure sensor module 100. In some examples, the plastic overmoulding 101 is sized to cover a metal cover (not shown) that surrounds or otherwise covers a sensing element. In some examples, by the application of heat and/or pressure, the plastic overmoulding 101 shrinks such that it is attached to the metal cover and the substrate and surrounds the metal cover and the substrate such that the metal cover and the substrate are not exposed or minimally exposed to the environment. In this way, the plastic overmoulding 101 assumes the shape of the metal cover and the substrate once heat and/or pressure are applied. In some examples, the metal cover comprises pyramidal base extending away from the substrate with a square/rectangular section extending therefrom. In some examples, the square/rectangular section may take the form of a non-uniform octagon or a square with cut corners.

In some embodiments, the plastic overmoulding 101 is comprised of at least one of: engineering plastics, high-temperature plastics, nylon, Bisphenol S (BPS), and/or liquid-crystal polymers (LCP). Applying plastic overmoulding to the pressure sensor module having a metal cover serves the dual purpose of safeguarding the MEMS pressure sensor(s) and/or ASIC(s) against direct contact with the plastic material and enabling the gel encapsulation to shield them from moisture, in some examples.

The plastic overmoulding 101, in some examples, defines pressure opening 102. In some embodiments, the pressure opening 102 allows a pressure sensing element (not shown) to sense the pressure of the environment and/or various media.

The plastic overmoulding 101 abuts a plurality of electrical terminals 103 that are coupled to and extend outwardly from a side of the substrate. In some embodiments, the plurality of electrical terminals 103 are configured to complete an electrical connection between at least one sensing element of the pressure sensor module 100 and an external device (not shown).

In some embodiments, the pressure sensor module 100 comprises a substrate (not shown) for housing components of the pressure sensor module 100 on a covered side and having the plurality of electrical terminals 103 on the alternative side. In some examples, the pressure sensing module includes at least one sensing element for sensing one or more characteristics of an environment of the pressure sensor module 100 (e.g., wherein the sensing element is coupled to the substrate) and a gel encapsulation of the at least one sensing element, the metal cover for the at least one sensing element. In some examples, the pressure sensor module 100 defines at least one pressure opening e.g., one or more pressure ports that are in communication the pressure opening 102. For example, the pressure sensor module 100 may comprise at least one or more pressure ports, wherein the one or more pressure ports are configured to carry the same or different media types.

In some embodiments, the substrate is comprised of flame-retardant woven glass-reinforced epoxy resin (FR4), think film nanocomposite (tFN), and/or other materials. In some examples, advantages of using FR4 substrates include affordability. In some examples, advantages of using tFN substrates include usability in applications in which FR4 substrates may not be used, offering greater stability to the sensor due to tFN and silicone having similar coefficients of thermal expression, offering thermal stability, and/or offering water resistance and/or waterproofing (e.g., since tFN does not absorb moisture).

In some embodiments, the substrate comprises at least one microelectromechanical system (MEMS) pressure sensor and/or at least one application-specific integrated circuit (ASIC). Utilizing overmoulding on FR4 and/or tFN substrates, in some examples, offers versatility in accommodating various MEMS pressure sensors and/or ASIC configurations, facilitating a wide array of assembled device combinations.

In some embodiments, the gel encapsulation is comprised of silicone gel or an equivalent thereof. For example, the gel encapsulation may shield the electrical components from moisture. In some examples, the metal cover is comprised of stainless steel, aluminum, and/or other materials. For example, the metal cover safeguards the MEMS pressure sensor(s) and/or ASIC(s) against direct contact with the plastic material.

In some embodiments, the FR4 and/or tFN substrate housing the sensor element with the metal cover and gel encapsulation is subjected to reflow, effectively forming the one or more terminals 103.

In some embodiments, advantages of this type of characteristic-sensing device (e.g., pressure-sensing device) include opening up a wide variety of applications, in some examples, such as automotive applications, battery pressure monitoring, and/or other high-volume applications due to the ease of fabrication of such devices.

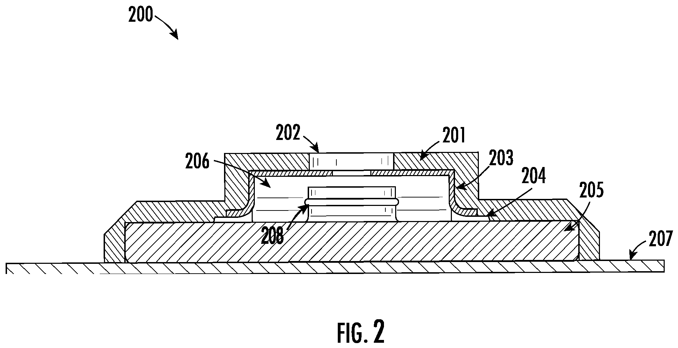

Referring now to FIG. 2, a cross-sectional view of the pressure sensor module of FIG. 1 is illustrated, in some example embodiments. A pressure sensor module 200, in some examples, comprises a substrate 205 for housing components of a pressure sensor module and at least one sensing element 208 extending away from the substrate 205 and configured for sensing one or more characteristics of an environment of the pressure sensor module 200.

In some examples, a gel encapsulation 206 surrounds the at least one sensing element 208 and is contained by a metal cover 203. In some examples, the metal cover defines an opening that is in communication with a pressure opening 202, which allows the at least one sensing element 208 to sense the characteristics of the environment and/or various media. In some examples, the metal cover 203 is spaced apart from the at least one sensing element 208 and is coupled to the substrate 205 via at least one area of industrial grade epoxy 204.

A plastic overmoulding 201, defining a pressure opening 202, surrounds the metal cover 203 and the substrate 205, in some examples. In some examples, the pressure opening 202 allows the at least one sensing element 208, which may be a pressure sensing element, to sense the characteristics (e.g., the pressure) of the environment and/or various media. The plastic overmoulding 201 surrounds the metal cover 203 and the substrate 205 and, in some examples, couples to a plurality of electrical terminals 207.

In some examples, the plastic overmoulding 201 assumes the shape of the metal cover 203 and the substrate 205. In some examples, the plurality of electrical terminals 207 are configured to complete an electrical connection between at least one sensing element 208 of the pressure sensor module 200 and an external device (not shown). In some examples, the plurality of electrical terminals 207 are coupled to the substrate 205 and are thereby in electrical contact with the sensing element 208. The at least one sensing element 208 is coupled to the substrate 205, in some examples.

While the description above provides example devices 100 and 200 for sensing characteristics of various media, it is noted that the scope of the present disclosure is not limited to the description above. In some examples, example devices 100 and 200 for sensing characteristics of various media in accordance with the present disclosure may be in other forms. In some examples, example devices 100 and 200 for sensing characteristics of various media may comprise one or more additional and/or alternative elements, and/or may be structured/positioned differently than illustrated herein.

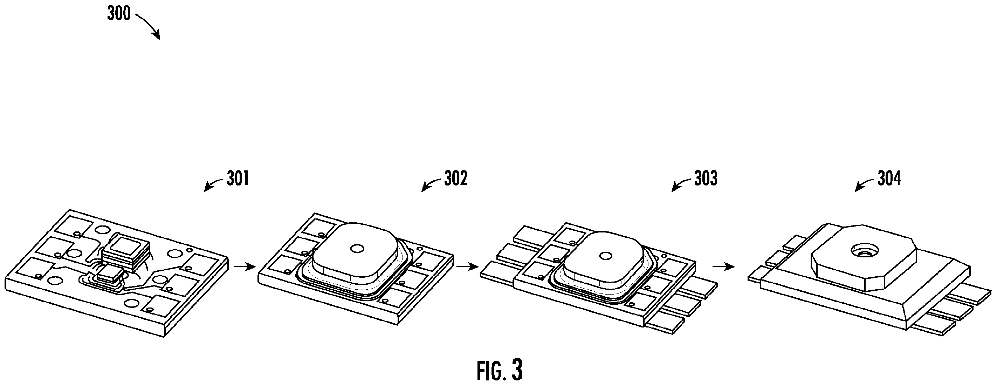

Referring now to FIG. 3, a series of perspective views showing the assembly of the device of FIG. 1 is illustrated. FIG. 3 shows a method 300 for assembling the pressure sensor module of FIG. 1. The method 300 includes step/operation 301, at which the electronics are assembled. In some embodiments, the electronics include the pressure sensing element, the MEMS pressure sensor, the ASIC, and/or other elements. The electronics may be coupled to the substrate. The electronics may be coupled to the substrate via soldering, solder paste, conductive adhesive, and/or other methods.

The method 300 includes step/operation 302, at which the metal cover is coupled to the substrate and the encapsulating gel is dispensed. In some examples, the encapsulating gel is dispensed via the opening in the metal cover. In some examples, the encapsulating gel is dispensed into the area surrounding the sensing element (and/or the MEMS die, the ASIC, and/or other electronic components) such that it fills in any gaps between the sensing element and the metal cover. The metal cover is coupled to the substrate via one or more areas of industrial epoxy resin, in some examples. The metal cover, in some examples, covers the sensing element and the encapsulating gel. In some examples, the encapsulating gel is silicone gel and/or Fluorosilicone gel.

The method 300 includes step/operation 303, at which a plurality of electrical terminals is coupled to the substrate. The plurality of electrical terminals is configured to complete an electrical connection between at least one sensing element of the pressure sensor module and an external device via physical contact with at least a portion of the substrate and/or a device, in some examples. For example, the terminals may be coupled to the substrate via an electrical connection.

The method 300 includes step/operation 304, at which the plastic overmoulding is coupled or otherwise deformed with heat and/or pressure such that it surrounds the pressure sensor module. The plastic overmoulding may be coupled to the pressure sensor module via a moulding machine for applying the plastic overmoulding to the pressure sensor module. Alternatively or additionally, the plastic overmoulding may be coupled to the pressure sensor module via other methods. The plastic overmoulding may define a pressure opening. The plastic overmoulding covers the metal cover and the substrate, in some examples.

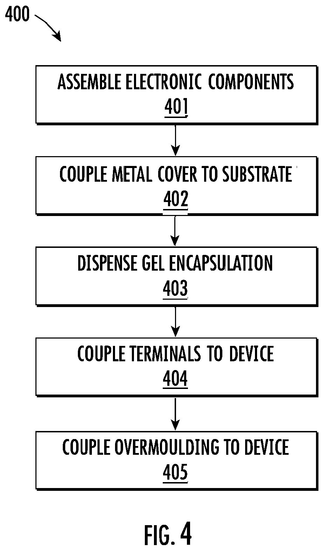

Reference will now be made to FIG. 4, which provides a flowchart illustrating example steps, processes, procedures, and/or operations in accordance with various embodiments of the present disclosure. Various methods described herein, including, for example, methods as shown in FIG. 4, may provide various technical benefits and improvements.

Referring now to FIG. 4, an example method 400 is illustrated. In some embodiments, the example method comprises mechanically and electrically coupling a sensor module to a device.

At step/operation 401, the electronic elements of the device are assembled. For example, the electronics may include the pressure sensing element, at least one MEMS pressure sensor, at least one ASIC, and/or other elements. In some examples, the electronic elements are coupled to a substrate comprised of FR4, tFN, and/or other materials. The electronics may be coupled to the substrate. In some examples, the electronics may be coupled to the substrate via soldering, solder paste, conductive adhesive, and/or other methods.

At step/operation 402, the metal cover is coupled to the substrate. In some examples, the metal cover is comprised of stainless steel, aluminum, and/or other materials. The metal cover may be coupled to the substrate via applying one or more areas of industrial epoxy resin. For example, the industrial epoxy resin is cured to solidify the joint between the metal cover and the substrate. The metal cover, in some examples, covers the electronics (e.g., the sensing element).

At step/operation 403, the gel encapsulation is dispensed. In some examples, the encapsulating gel is dispensed via the opening in the metal cover. In some examples, the encapsulating gel is dispensed into the area surrounding the sensing element (and/or the MEMS die, the ASIC, and/or other electronic components) such that it fills in any gaps between the sensing element and the metal cover. In some embodiments, the encapsulating gel is silicone gel, a Fluorosilicone gel, and/or other materials. In some examples, the encapsulating gel safeguards the MEMS pressure sensor(s) and/or ASIC(s) against moisture, elongating the life of the device as a whole. The metal cover, in some examples, covers the gel encapsulation.

At step/operation 404, a plurality of electrical terminals is coupled to the device. In some embodiments, the plurality of electrical terminals is configured to complete an electrical connection between at least one sensing element of the pressure sensor module and an external device via physical contact with at least a portion of the external device. For example, the terminals may be coupled to the substrate via an electrical connection.

At step/operation 405, the plastic overmoulding is coupled or otherwise deformed with heat and/or pressure such that it surrounds the components (e.g., the substrate, the metal cover, etc.) of the pressure sensor module. The plastic overmoulding may define a pressure opening. In some examples, the plastic overmoulding covers the metal cover and the substrate. In some examples, the plastic overmoulding is comprised of engineering plastics, high-temperature plastics, nylon, Bisphenol S (BPS), liquid-crystal polymers, and/or other materials. Coupling the plastic overmoulding to the pressure sensor module, in some examples, further comprises inserting the pressure sensor module into a moulding machine for applying the plastic overmoulding to the pressure sensor module.

Operations and processes described herein support combinations of means for performing the specified functions and combinations of operations for performing the specified functions. It will be understood that one or more operations, and combinations of operations, may be implemented by special purpose hardware-based computer systems which perform the specified functions, or combinations of special purpose hardware and computer instructions.

In some example embodiments, certain ones of the operations herein may be modified or further amplified as described below. Moreover, in some embodiments additional optional operations may also be included. It should be appreciated that each of the modifications, optional additions or amplifications described herein may be included with the operations herein either alone or in combination with any others among the features described herein.

The foregoing method and process descriptions are provided merely as illustrative examples and are not intended to require or imply that the steps of the various embodiments must be performed in the order presented. As will be appreciated by one of skill in the art the order of steps in the foregoing embodiments may be performed in any order. Words such as "thereafter," "then," "next," and similar words are not intended to limit the order of the steps; these words are simply used to guide the reader through the description of the methods. Further, any reference to claim elements in the singular, for example, using the articles "a," "an" or "the," is not to be construed as limiting the element to the singular and may, in some instances, be construed in the plural.

While various embodiments in accordance with the principles disclosed herein have been shown and described above, modifications thereof may be made by one skilled in the art without departing from the teachings of the disclosure. The embodiments described herein are representative only and are not intended to be limiting. Many variations, combinations, and modifications are possible and are within the scope of the disclosure. Alternative embodiments that result from combining, integrating, and/or omitting features of the embodiment(s) are also within the scope of the disclosure. Accordingly, the scope of protection is not limited by the description set out above, but is defined by the claims which follow, that scope including all equivalents of the subject matter of the claims. Each and every claim is incorporated as further disclosure into the specification and the claims are embodiment(s) of the present disclosure. Furthermore, any advantages and features described above may relate to specific embodiments but shall not limit the application of such issued claims to processes and structures accomplishing any or all of the above advantages or having any or all of the above features.

In addition, the section headings used herein are provided for consistency with the suggestions under 37 C.F.R. § 1.77 or to otherwise provide organizational cues. These headings shall not limit or characterize the disclosure set out in any claims that may issue from this disclosure. For instance, a description of a technology in the "Background" is not to be construed as an admission that certain technology is prior art to any disclosure in this disclosure. Neither is the "Summary" to be considered as a limiting characterization of the disclosure set forth in issued claims. Furthermore, any reference in this disclosure to "disclosure" or "embodiment" in the singular should not be used to argue that there is only a single point of novelty in this disclosure. Multiple embodiments of the present disclosure may be set forth according to the limitations of the multiple claims issuing from this disclosure, and such claims accordingly define the disclosure, and their equivalents, which are protected thereby. In all instances, the scope of the claims shall be considered on their own merits in light of this disclosure but should not be constrained by the headings set forth herein.

Also, systems, subsystems, apparatuses, techniques, and methods described and illustrated in the various embodiments as discrete or separate may be combined or integrated with other systems, modules, techniques, or methods without departing from the scope of the present disclosure. Other devices or components shown or discussed as coupled to, or in communication with, each other may be indirectly coupled through some intermediate device or component, whether electrically, mechanically, or otherwise. Other examples of changes, substitutions, and alterations are ascertainable by one skilled in the art and could be made without departing from the scope disclosed herein.

Many modifications and other embodiments of the disclosure set forth herein will come to mind to one skilled in the art to which these embodiments pertain having the benefit of teachings presented in the foregoing descriptions and the associated figures. Although the figures only show certain components of the apparatuses and systems described herein, various other components may be used in conjunction with the components and structures disclosed herein. Therefore, it is to be understood that the disclosure is not to be limited to the specific embodiments disclosed and that modifications and other embodiments are intended to be included within the scope of the appended claims. For example, the various elements or components may be combined, rearranged, or integrated in another system or certain features may be omitted or not implemented. Moreover, the steps in any method described above may not necessarily occur in the order depicted in the accompanying drawings, and in some cases one or more of the steps depicted may occur substantially simultaneously, or additional steps may be involved. Although specific terms are employed herein, they are used in a generic and descriptive sense only and not for purposes of limitation.

## Claims

1. A device comprising:
a housing for a sensor module;
wherein the sensor module comprises:
a substrate for housing a pressure sensor module;
at least one sensing element for sensing one or more characteristics of an environment of the sensor module, wherein the at least one sensing element is coupled to the substrate;
a gel encapsulation of the at least one sensing element;
a metal cover for covering the at least one sensing element and the gel encapsulation, wherein the metal cover is coupled to the substrate; and
a plastic overmoulding defining a pressure opening, wherein the plastic overmoulding is deformable such that it covers the metal cover and the substrate.

2. The device of claim 1, wherein the sensor module comprises a plurality of electrical terminals configured to complete an electrical connection between the at least one sensing element of the sensor module and the device via physical contact with at least a portion of the device.

3. The device of any of claims 1 or 2, wherein the sensor module is a pressure sensor module.

4. The device of any of claims 1 to 3, wherein the substrate is comprised of one or more of:
flame-retardant woven glass-reinforced epoxy resin (FR4); or
thin film nanocomposite (tFN).

5. The device of any of claims 1 to 4, wherein the substrate further comprises:
at least one microelectromechanical system (MEMS) pressure sensor; and
at least one application-specific integrated circuit (ASIC).

6. The device of any of claims 1 to 5, wherein the gel is comprised of at least one of:
silicone gel; or
a Fluorosilicone gel.

7. The device of any of claims 1 to 6, wherein the metal cover is comprised of at least one of:
stainless steel; or
aluminum.

8. The device of any of claims 1 to 7, wherein the plastic overmoulding is comprised of at least one of:
engineering plastics;
high-temperature plastics;
nylon;
Bisphenol S (BPS); or
liquid-crystal polymers (LCP).

9. A sensor module comprising:
a substrate for housing a pressure sensor module;
at least one sensing element for sensing one or more characteristics of an environment of the sensor module, wherein the at least one sensing element is coupled to the substrate;
a gel encapsulation of the at least one sensing element;
a metal cover for covering the at least one sensing element and the gel encapsulation, wherein the metal cover is coupled to the substrate;
a plastic overmoulding defining a pressure opening, wherein the plastic overmoulding is deformable such that it covers the metal cover and the substrate; and
a plurality of electrical terminals configured to complete an electrical connection between the at least one sensing element of the sensor module and an external device via physical contact with at least a portion of the external device.

10. The sensor module of claim 9, wherein the substrate is comprised of one or more of:
flame-retardant woven glass-reinforced epoxy resin (FR4); or
thin film nanocomposite (tFN).

11. The sensor module of any of claims 9 or 10, wherein the substrate further comprises:
at least one microelectromechanical system (MEMS) pressure sensor; and
at least one application-specific integrated circuit (ASIC).

12. The sensor module of any of claims 9 to 11, wherein the gel is comprised of at least one of:
silicone gel; or
a Fluorosilicone gel.

13. The sensor module of any of claims 9 to 12, wherein the metal cover is comprised of at least one of:
stainless steel; or
aluminum.

14. The sensor module of any of claims 9 to 13, wherein the plastic overmoulding is comprised of at least one of:
engineering plastics;
high-temperature plastics;
nylon;
Bisphenol S (BPS); or
liquid-crystal polymers (LCP).

15. A method comprising:
assembling electronics of a pressure sensor module onto a substrate, wherein the electronics comprise at least one sensing element;
coupling a metal cover to the pressure sensor module;
dispensing a gel material for encapsulating the at least one sensing element of the pressure sensor module;
coupling a plurality of electrical terminals to the substrate; and
coupling a plastic overmoulding to the pressure sensor module.
